# EUROPÄISCHE PATENTANMELDUNG

(11) **EP 1 217 717 A2**
(43) Veröffentlichungstag der Anmeldung: **26.06.2002**
(21) Anmeldenummer: 01000776.3
(22) Anmeldetag: 20.12.2001
(51) Int. Cl.: H02M 3/07

(54) **Adaptive Phasensteuerung für Ladungspumpen**

(30) Priorität: 22.12.2000 DE 10064819
(71) Anmelder: Philips Corporate Intellectual Property GmbH, 52066 Aachen (DE); Koninklijke Philips Electronics N.V., 5621 BA Eindhoven (NL)
(72) Erfinder: Brani, Francesco M., 52066, Aachen (DE)
(74) Vertreter: Volmer, Georg, Dipl.-Ing.

(57) **Zusammenfassung**

Die Erfindung betrifft eine Anordnung zur Steuerung der Phasen einer Ladungspumpe 20 mit einem Phasengenerator 9 und einer mehrere Stufen 1,2 enthaltenden Ladungspumpe. Außerdem betrifft die Erfindung eine Treiberschaltung zur Ansteuerung einer Anzeigevorrichtung mit einer Ladungspumpe und einem Phasengenerator und eine Anzeigevorrichtung mit einer Treiberschaltung und eine Ladungspumpe und einem Phasengenerator. Um die Verzögerungen zwischen den einzelnen Phasen P1-P4 zur Steuerung einer Ladungspumpe optimal einzustellen und auf Störungen, die durch Last- oder Temperaturänderungen hervorgerufen werden, reagieren zu können, werden Signale 14-17 der Ladungspumpe zu einem Phasengenerator 9 zurückführt, so dass die Phasen erst gestartet werden, wenn die entsprechenden Bedingungen oder Zustände der anderen Phasen vorliegen.

## Beschreibung

Die Erfindung betrifft eine Anordnung zur Steuerung von Phasen einer Ladungspumpe mit einem Phasengenerator und einer mehrere Stufen enthaltenden Ladungspumpe. Außerdem behifft die Erfindung eine Treiberschaltung zur Ansteuerung einer Anzeigevorrichtung mit einer Ladungspumpe und einem Phasengenerator und eine Anzeigevorrichtung mit einer Treiberschaltung und einer Ladungspumpe und einem Phasengenerator.

Spannungsvervielfacher werden in Geräten benötigt, in denen eine höhere Spannung erforderlich ist, als die Versorgungsspannung. Insbesondere werden diese Spannungsvervielfacher für Treiberschaltungen für Anzeigevorrichtungen verwendet. Um Flüssigkristallanzeigen anzusteuern, ist es notwendig Spannungen bereitzustellen, die die Versorgungsspannung des Treiberschaltkreises um ein Vielfaches übersteigen. Spannungsvervielfacherschaltungen werden üblicher weise als Ladungspumpen ausgeführt, die an der zur Verfügung stehenden Systemversorgungsspannung betrieben werden und die Systemversorgungsspannung durch die Serienschaltung von Pumpstufen auf die erforderliche Ausgangsspannung hochpumpen. Eine Pumpstufe besteht dabei aus einer Schalteinrichtung und einem Ladungsspeicherelement. Die Spannungsvervielfacher sind dabei mehrstufig aufgebaut, wobei eine Ladung in einer ersten Stufe in einer ersten Phase gespeichert wird und in der zweiten Phase auf die nachfolgende Stufe übertragen wird, so dass abhängig von der Anzahl der Stufen eine höhere Spannung als die Versorgungsspannung gesammelt wird.

In der DE 19639701 wird eine Regelschaltung für Ladungspumpen angegeben, bei der die Ausgangsspannung überwacht wird Ein von der Ausgangsspannung abhängiges Steuersignal wird über einen Komparator den Treibern der Ladungspumpe zugeführt. Damit wird ein Ein- oder Ausschalten der Ladungspumpe in Abhängigkeit der Ausgangsspannung ermöglicht.

Inkorrekte Verzögerungen zwischen den Flanken der Phasen beeinträchtigen die Performance der Ladungspumpe.

Bisher wurden die Phasen mit einem festen Abstand erzeugt. Dazu werden mittels eines Taktsignals, welches einer Logikschaltung zugeführt wird, die Phasen mit festen Abständen erzeugt. Durch diese feste Einstellung werden anwendungsspezifische Bedingungen bei der Erzeugung der Phasen nicht berücksichtigt. Insbesondere Lastveränderungen der Ladungspumpe, Temperaturschwankungen oder Parameter, die durch Herstellungsprozesse beeinflusst werden, wirken sich negativ auf die Abstände zwischen den Phasen aus, so dass die Steuerung der Phasen zu einer Beeinflussung der Wirksamkeit der Ladungspumpe und somit des gesamten Gerätes führen kann oder auch zu einem kompletten Ausfall der Ladungspumpe. Die Last der Ladungspumpe hat entscheidenden Einfluss auf die Steilheit der Flanken, wodurch eine genaue und effiziente Phasensteuerung der einzelnen Stufen der Ladungspumpe nicht möglich ist.

Um durch inkorrekte Phasen entstehende Überlappungen bei der Steuerung der Ladungs- und Schaltvorgänge der einzelne Stufen der Ladungspumpe zu vermeiden, werden die Verzögerungen bisher zwischen den einzelnen Phasen so groß gewählt, dass oben erwähnte Effekte die Ladungspumpe in ihrem Betrieb weitestgehend nicht beeinflussen. Zwischen dem Übergang von Stufe 1 zur Stufe 2 ist eine entsprechend große Verzögerung implementiert, die genügend Sicherheit gegen Störeinflüsse bietet, so dass die Zeit nicht effektiv genutzt wird, was auf die Schnelligkeit der Bereitstellung von entsprechend hohen Spannungswerten negative Auswirkungen hat und sich auch auf die Performance des Gesamtgerätes niederschlägt.

Aufgabe der Erfindung ist es, eine Anordnung anzugeben, mit der eine gegen Störungen unanfällige Steuerung der Verzögerungen zwischen den einzelnen Phasen einer Ladungspumpe ermöglicht wird.

Diese Aufgabe wird dadurch gelöst, dass eine Anordnung zur Steuerung der Phasen einer Ladungspumpe vorgesehen ist, mit einem Phasengenerator, einer mehrere Stufen enthaltenden Ladungspumpe, bei der zur adaptiven Anpassung der Phasen der Stufen der Ladungspumpe vorgesehen ist, dem Phasengenerator Signale der Ladungspumpe zuzuführen.

Eine Ladungspumpe enthält mehrere Stufen, die derart angeordnet sind, dass die Ladungsspeichereinrichtung der ersten Stufe mittels des vorgeschalteten Treibers mit einer von der Versorgungsspannung abhängigen Ladung geladen wird Dabei muss die zu dieser Stufe gehörende Schalteinrichtung geöffnet sein. Dann schließt die Schalteinrichtung so dass die Ladung zur nächsten Stufe abfließen kann. Die Ladungsspeichereinrichtung der nachfolgenden Stufe wird von einem dieser vorgeschalteten Treiber geladen. Auch dabei ist die Schalteinrichtung des Schalters dieser Stufe leitend.

Dem Phasengenerator wird jeweils ein Signal zugeführt, welches zwischen Ladungs-Speichereinrichtung und Treiber abgegriffen wird. Außerdem wird von der jeweiligen Stufe der Ladungspumpe auch noch je ein Signal von der Schalteinrichtung abgegriffen und dem Phasengenerator zugeführt. Dabei geben die von der Ladungspumpe zum Phasengenerator zurückgeführten Signale an, dass die entsprechenden Flanken beendet sind.

Dadurch wird erreicht, dass die nächste Phase erst dann gestartet wird, wenn die Bedingungen dafür vorhanden sind Auf Verzögerungen, die durch hohe Lasten der Ladungspumpe hervorgerufen werden, kann somit im Phasengenerator reagiert werden und die nachfolgenden Phasen entsprechend später gestartet werden.

Vorteilhaft ist dabei, dass im Idealfall die Ladungspumpe mit optimalen Verzögerungszeiten zwischen den einzelnen Phasen betrieben werden kann und gleichzeitig Störeinflüsse ein Funktionieren der Ladungspumpe nicht beeinflussen.

Die erfindungsgemäße Anordnung kann auch in entsprechender Ausführung an mehr als zwei Stufen betrieben werden. Ein sinnvoller Kompromiss zwischen zusätzlichem Schaltungsaufwand und gewonnener Funktionalität kann erzielt werden, wenn die letzten zwei Stufen der Ladungspumpe erfindungsgemäß überwacht werden, da sich Störungen hier ganz besonders stark auswirken.

Die Aufgabe wird auch mittels einer Treiberschaltung zur Ansteuerung einer Anzeigevorrichtungen mit einer Ladungspumpe und einem Phasengenerator gelöst, bei der vorgesehen ist, Signale der Ladungspumpe zur adaptiven Steuerung der Phasen dem Phasengenerator zuzuführen.

Die erfindungsgemäße Anordnung findet ihre Anwendung insbesondere bei Treiberschaltungen für Anzeigevorrichtungen, die zur Erzeugung der entsprechend hohen Spannungen benötigt werden, die erforderlich sind, auf einem Display entsprechende Bildinformation anzuzeigen.

Die Aufgabe wird außerdem durch eine Anzeigevorrichtung gelöst, mit einer Treiberschaltung zur Ansteuerung der Anzeigevorrichtung, mit einer Ladungspumpe zur Erzeugung hoher Spannungen und einem Phasengenerator, dem Signale von der Ladungspumpe zugeführt werden.

Die Erfindung wird nun anhand von in den Zeichnungen dargestellten Ausführungsbeispielen näher beschrieben und erläutert. Es zeigen:
- Fig. 1: Prinzipschaltung der erfindungsgemäßen Anordnung
- Fig. 2: Phasendiagramm korrespondierend zur Fig. 1

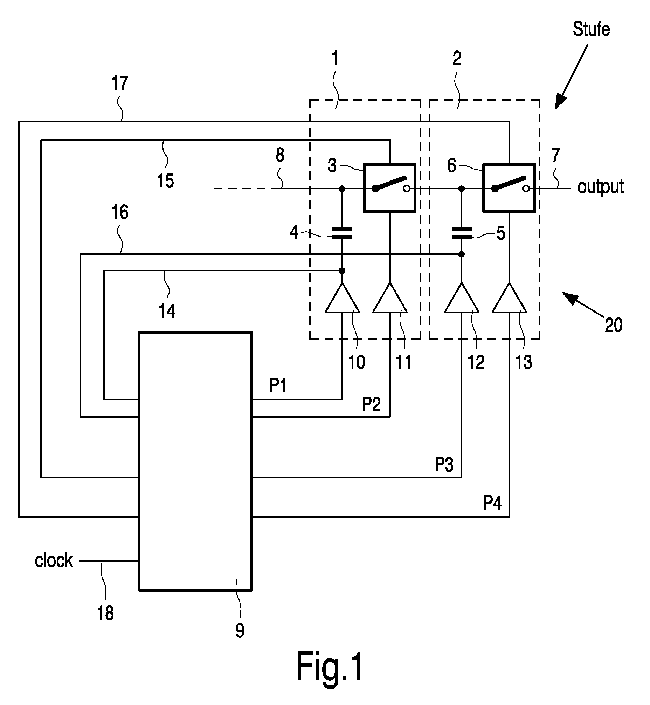

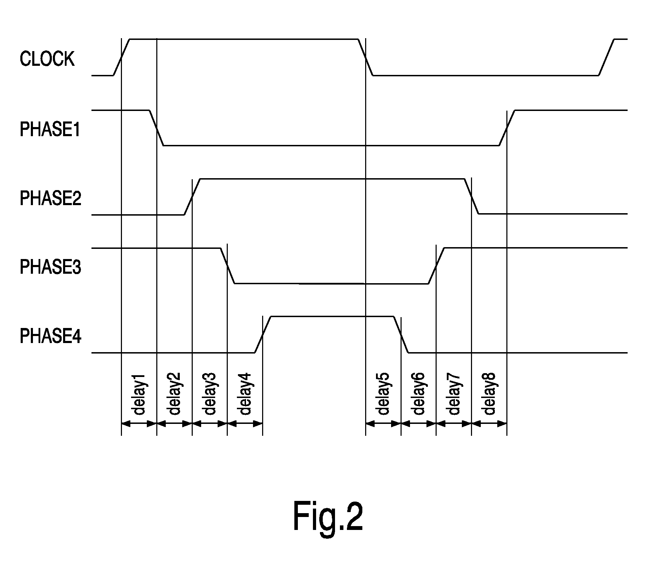

Figur 1 zeigt eine zweistufige Ladungspumpe 20. Dabei enthält Stufe 1 eine Schalteinrichtung 3 und eine Ladungsspeicherungsvorrichtung 4, die als Kondensator ausgeführt ist. Die Stufe 2 enthält in gleicher Weise einen Schalter 6 und einen Kondensator 5. Am Eingang 8 dieser Schaltung können sich weitere gleichartige Stufen befinden. Am Ausgang 7 wird die erzeugte höhere Spannung an den angeschlossenen Verbraucher abgegeben, bspw. an ein LCD. Der Phasengenerator 9 erzeugt mittels einer Logikschaltung die vier unterschiedlichen Phasen P1- P4, die in Figur 2 näher dargestellt sind.

Phase 1 wird über den Treiber 10 dem Kondensator 4 der Stufe 1 zugerührt. Phase 2 wird dem Treiber 11 zur Steuerung der Schalteinrichtung 3 der Stufe 1 zugeführt. Das Signal 14 gibt den Zustand der Phase 1 an und wird zwischen dem Treiber 10 und dem Kondensator 4 abgegriffen und dem Phasengenerator 9 zugeführt. Das Signal 15 gibt den Zustand der Schalteinrichtung 3 an und wird dem Phasengenerator 9 zugeführt. Analog dazu wird die Phase 3 über den Treiber 12 dem Kondensator 5 zugeführt und steuert somit den Ladevorgang des Kondensators. Das Signal 16 gibt den Zustand der Phase 3 an und wird zwischen Treiber 12 und Kondensator 5 abgegriffen und dem Phasengenerator 9 zugeführt. Die Phase 4 wird dem Treiber 13 zur Steuerung der Schalteinrichtung 6 zugeführt. Das Signal 17 wird von der Schalteinrichtung 6 abgeführt und gibt den Zustand der Phase 4 an und wird dem Phasengenerator 9 zugeführt. Mit einem Taktsignal 18 wird der Phasengenerator getaktet.

Figur 2 zeigt die Schaltzustände der einzelnen Phasen 1- 4 und das Taktsignal 18. Die angezeigten Verzögerungen (delay 1-8) sind hier gleichmäßig kurz dargestellt. Es ist ersichtlich, dass Phase 2 erst gestartet werden kann, wenn die Phase 1 abgeschlossen ist. Ebenso kann Phase 3 erst den Zustand wechseln, wenn Phase 2 in den entsprechenden on Zustand geschaltet wurde.

## Patentansprüche

1. Anordnung zur Steuerung von Phasen (P1-P4) einer Ladungspumpe (20)
mit einem Phasengenerator (9), einer mehrere Stufen (1,2) enthaltenden Ladungspumpe (20), bei der zur adaptiven Anpassung der Phasen (P1-P4) der Stufen (1,2) der Ladungspumpe (20) vorgesehen ist, dem Phasengenerator (9) Signale (14-17) der Ladungspumpe (20) zuzuführen.

2. Anordnung nach Anspruch 1,
**dadurch gekennzeichnet,**
**dass** eine Stufe (1) eine Schalteinheit (3) und eine Ladungsspeicherungsvorrichtung (4) enthält und ein Treiber (10) zum Aufladen der Ladungsspeicherungsvorrichtung (4) vorgesehen ist.

3. Anordnung nach Anspruch 1,
**dadurch gekennzeichnet,**
**dass** vorgesehen ist, dem Phasengenerator (9) je ein Signal (15) einer Schalteineinheit (3) und ein Signal (14) der Ladungsspeicherungsvorrichtung (4) zuzuführen.

4. Anordnung nach Anspruch 1,
**dadurch gekennzeichnet,**
**dass** von wenigstens zwei Stufen (1,2) je zwei Signale (14,15;16,17) zur Zuführung zum Phasengenerator (9) vorgesehen sind

5. Treiberschaltung zur Ansteuerung einer Anzeigevorrichtungen mit einer Ladungspumpe (20) und einem Phasengenerator (9), bei der vorgesehen ist, Signale (14-17) der Ladungspumpe (20) zur adaptiven Steuerung der Phasen (P1-P4) dem Phasengenerator (9) zuzuführen.

6. Anzeigevorrichtung mit einer Treiberschaltung zur Ansteuerung der Anzeigevorrichtung mit einer Ladungspumpe (20) zur Erzeugung hoher Spannungen und einem Phasengenerator (9), wobei vorgesehen ist, dem Phasengenerator (9) Signale (14-17) der Ladungspumpe (20) zuzuführen.
